# EUROPÄISCHE PATENTANMELDUNG

(11) **EP 3 955 713 A1**
(43) Veröffentlichungstag der Anmeldung: **16.02.2022**
(21) Anmeldenummer: 20191160.9
(22) Anmeldetag: 14.08.2020
(51) Int. Cl.: H05K 3/36, H05K 1/11

(54) **LEITERPLATTE ZUM ANBINDEN EINER PARALLEL ANGEORDNETEN KONTAKTIERUNGSLEITERPLATTE**

(71) Anmelder: Kamedi GmbH, 76131 Karlsruhe (DE)
(72) Erfinder: Reuter, Christof, 77948 Friesenheim (DE); Meyer, Armin, 76131 Karlsruhe (DE); Jacob, Stefan, 76275 Ettlingen (DE)
(74) Vertreter: Durm Patentanwälte PartG mbB

(57) **Zusammenfassung**

Die vorliegende Erfindung betrifft eine Leiterplatte (12) zum Anbinden einer parallel angeordneten Kontaktierungsleiterplatte (14), mit: einem Ausschnitt (20) im Bereich einer Stirnseite (22) der Leiterplatte zum Aufnehmen der Kontaktierungsleiterplatte, wobei der Ausschnitt stirnseitig offen ist und durch mindestens einen parallel zu einer Oberfläche der Leiterplatte verlaufenden ersten Überstand (24) der Leiterplatte begrenzt wird; einer ersten Metallfläche (28) zum Kontaktieren mit einer ersten Kontaktierungsmetallfläche (32) auf der Kontaktierungsleiterplatte, wenn die Kontaktierungsleiterplatte in dem stirnseitigen Ausschnitt aufgenommen ist, wobei die erste Metallfläche in dem stirnseitigen Ausschnitt an dem ersten Überstand parallel zu der Leiterplatte angeordnet ist. Die vorliegende Erfindung betrifft weiterhin eine Leiterplattenanordnung (10) sowie ein Verfahren zum Herstellen einer Leiterplatte (12) nach oder einer Leiterplattenanordnung.

## Beschreibung

Die vorliegende Erfindung betrifft eine Leiterplatte zum Anbinden einer parallel angeordneten Kontaktierungsleiterplatte. Die vorliegende Erfindung betrifft weiterhin eine Leiterplattenanordnung sowie ein Verfahren zum Herstellen einer Leiterplatte.

Elektronische Schaltungen werden heutzutage mit immer weniger Bauteilen aufgebaut und zunehmend miniaturisiert. Dennoch gibt es Anwendungsfälle, in denen aufgrund von Bauraumanforderungen oder Vorgaben von Zulieferern eine elektronische und mechanische Verbindung von Leiterplatten notwendig ist. Wenn beispielsweise vorgefertigte Baugruppen bzw. Baugruppen unterschiedlicher Hersteller verwendet werden, können elektronische Schaltungen auf mehrere einzelne Leiterplatten aufgeteilt sein. Es muss dann ein Informations- und Energiefluss zwischen den einzelnen Baugruppen bzw. zwischen den jeweiligen Leiterplatten hergestellt werden. Neben den elektronischen Anforderungen können dabei auch mechanische Anforderungen, wie beispielsweise eine genaue Positionierung oder eine ausreichende mechanische Stabilität, bestehen. Zudem kann es zur Sicherstellung einer effizienten Herstellung notwendig sein, auf eine Verbindung zwischen Leiterplatten zurückzugreifen.

Zum Verbinden von Leiterplatten gibt es in diesem Zusammenhang unterschiedliche Ansätze. Einerseits kann eine Verbindung über Bonddrähte hergestellt werden, wobei Kontakte auf den zu verbindenden Leiterplatten mit Einzelleitern verbunden werden. Ein Nachteil liegt in der erforderlichen genauen Positionierung der Leiterplatten zueinander. Zudem ergibt sich eine vergleichsweise hohe Prozesskomplexität, die einerseits zu hohen Herstellungskosten und andererseits auch zu einer größeren Fehleranfälligkeit führt. Eine andere Möglichkeit liegt in der Verbindung von Leiterplatten über gestanzte Bondverbinder. Diese verringern zwar die Prozesskomplexität, weisen aber dennoch die zuvor beschriebenen Nachteile auf. Ein weiterer oft verwendeter Ansatz zum Verbinden von Leiterplatten liegt in der Verwendung von Steckverbindern. Diese können beispielsweise gelötet werden oder auch den Daten- und Energiefluss über eine mechanische Klemmung erreichen. Nachteilig an diesem Ansatz ist, dass keine beidseitige Kontaktierung hergestellt werden kann, sodass sich eine höhere Bauraumanforderung ergibt. Zudem ist es notwendig, beide zu verbindenden Leiterplatten entsprechend auszugestalten, sodass eine Verwendung von fertigen Leiterplatten von Zulieferern nicht möglich ist. Zuletzt gibt es die Möglichkeit, Leiterplatten durch die Verwendung von überfederten Stiften oder ähnlichen mechanischen Verbindungen zu koppeln. Diese haben jedoch Nachteile hinsichtlich der Wirtschaftlichkeit, der mechanischen Stabilität und des benötigten Bauraums.

Ausgehend hiervon stellt sich der vorliegenden Erfindung die Aufgabe, eine effizient fertigbare Verbindung von parallel angeordneten Leiterplatten mit hoher mechanischer Stabilität zu schaffen. Insbesondere soll eine mechanisch stabile und effizient herstellbare (mechanische und elektronische) Anbindung einer Leiterplatte an eine zugelieferte Leiterplatte, auf deren Ausgestaltung kein Einfluss genommen werden kann, ermöglicht werden.

Zum Lösen dieser Aufgabe betrifft die vorliegende Erfindung in einem ersten Aspekt eine Leiterplatte zum Anbinden einer parallel angeordneten Kontaktierungsleiterplatte, mit:
- einem Ausschnitt im Bereich einer Stirnseite der Leiterplatte zum Aufnehmen der Kontaktierungsleiterplatte, wobei der Ausschnitt stirnseitig offen ist und durch mindestens einen parallel zu einer Oberfläche der Leiterplatte verlaufenden ersten Überstand der Leiterplatte begrenzt wird;
- einer ersten Metallfläche zum Kontaktieren mit einer ersten Kontaktierungsmetallfläche auf der Kontaktierungsleiterplatte, wenn die Kontaktierungsleiterplatte in dem stirnseitigen Ausschnitt aufgenommen ist, wobei die erste Metallfläche in dem stirnseitigen Ausschnitt an dem ersten Überstand parallel zu der Leiterplatte angeordnet ist.

In einem weiteren Aspekt betrifft die vorliegende Erfindung eine Leiterplattenanordnung, mit:
- einer Leiterplatte wie zuvor beschrieben; und
- einer in dem stirnseitigen Ausschnitt der Leiterplatte aufgenommenen Kontaktierungsleiterplatte, wobei
- auf der Kontaktierungsleiterplatte vorzugsweise ein Stecker, besonders bevorzugt ein Lightning-Stecker, angeordnet ist.

In einem weiteren Aspekt betrifft die vorliegende Erfindung ein Verfahren zum Herstellen einer Leiterplatte wie zuvor beschrieben oder einer Leiterplattenanordnung wie zuvor beschrieben, mit den Schritten:
- Ausfräsen eines Ausschnitts im Bereich einer Stirnseite einer ersten Schicht einer mehrschichtigen Platine;
- Herstellen einer ersten Metallfläche auf einer zweiten Schicht der mehrschichtigen Platine; und
- Verbinden der ersten Schicht mit der zweiten Schicht.

Bevorzugte Ausgestaltungen der Erfindung werden in den abhängigen Ansprüchen beschrieben. Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorstehenden Erfindung zu verlassen. Insbesondere können die Leiterplattenanordnung und das Verfahren entsprechend den für die Leiterplatte in den abhängigen Ansprüchen beschriebenen Ausgestaltungen ausgeführt sein.

Erfindungsgemäß ist es vorgesehen, dass eine Leiterplatte im Bereich ihrer Stirnseite einen Ausschnitt aufweist. In diesen Ausschnitt kann eine parallel angeordnete Kontaktierungsleiterplatte aufgenommen werden. Der Begriff Kontaktierungsleiterplatte ist hierbei zur besseren Unterscheidbarkeit gewählt und bezeichnet eine andere Leiterplatte, die mit der Leiterplatte verbunden werden soll. Insbesondere kann die Kontaktierungsleiterplatte dabei eine Baugruppe mit einem Stecker umfassen. Leiterplatte und Kontaktierungsleiterplatte verlaufen parallel zueinander und sind insbesondere fluchtend angeordnet.

Für die elektronische, aber auch mechanische Kontaktierung wird eine erste Metallfläche auf der Leiterplatte mit einer Kontaktierungsmetallfläche auf der Kontaktierungsleiterplatte verbunden. Die Verbindung zwischen Metallfläche und Kontaktierungsmetallfläche erfolgt dabei vorzugsweise direkt, insbesondere durch ein Einbringen eines entsprechenden Lötmaterials (insbesondere Lötzinn bzw. Lot) zwischen die beiden Metallflächen. Die Kontaktierungsleiterplatte ist an der Stirnseite der Leiterplatte und parallel zur Leiterplatte angeordnet und wird mittels der Kontaktierungsmetallfläche bzw. der Metallfläche mit dieser verbunden. Der Ausschnitt kann sich dabei über die ganze Breite der ersten Leiterplatte oder lediglich über einen Teilbereich erstrecken. Der Ausschnitt wird von einem Überstand begrenzt. In anderen Worten überragt ein Teil der Leiterplatte einen anderen Teil. Der Überstand weist eine Dicke auf, die geringer als eine Dicke der Leiterplatte ist. Insbesondere kann sich der Überstand über die gesamte oder zumindest einen Großteil der Breite der Leiterplatte entlang ihrer Stirnseite erstrecken. Nach der Verbindung mit der Kontaktierungsleiterplatte ergibt sich eine stoffschlüssige und mechanisch stabile Verbindung.

Im Vergleich zu bisherigen Ansätzen für das Verbinden von zwei parallel angeordneten Leiterplatten ergibt sich insbesondere der Vorteil, dass eine einfach und effizient herstellbare Verbindung von zwei parallel angeordneten Leiterplatten realisiert werden kann, ohne dass beide Leiterplatten besonderen Anforderungen genügen müssen bzw. entsprechend designt sein müssen. Es ist ausreichend, dass eine Leiterplatte einen Ausschnitt und eine erste Metallfläche wie zuvor beschrieben aufweist. Neben dem im Bestückungsprozess der Leiterplatte sowieso verwendeten Lötzinns werden keine weiteren Bauteile für die Verbindung benötigt. Wenn beispielsweise eine Kontaktierungsleiterplatte mit einem darauf angeordneten Stecker von einem Lieferanten bezogen wird, kann der Stecker auf effiziente Art und Weise mit der Leiterplatte bzw. den darauf angeordneten Bauteilen verbunden werden. Die Kontaktierungsleiterplatte kann dabei ohne weitere Anpassung verwendet werden. Es ist nicht erforderlich, dass diese in irgendeiner Weise modifiziert wird, um an die Leiterplatte angebunden zu werden.

Zudem werden bei der Ausgestaltung der Leiterplatte keine spezifischen Anforderungen hinsichtlich der Verbindung gestellt. Möglicherweise kann die Verbindung zwischen den Leiterplatten sogar bereits im Bestückungsprozess der Leiterplatte erfolgen. Hierdurch ergeben sich weitere Kostenvorteile. Es wird möglich, automatisierte Bestückungsverfahren einzusetzen, da für die Verbindung keine weiteren Bauelemente notwendig sind. Zudem erlaubt die erfindungsgemäße Verbindung eine effiziente Ausnutzung vorhandenen Bauraums, sodass sich bezüglich einer Miniaturisierung Vorteile ergeben.

In einer bevorzugten Ausgestaltung umfasst die Leiterplatte einen zweiten Überstand, der parallel zu der Oberfläche der Leiterplatte verläuft und den stirnseitigen Ausschnitt auf einer dem ersten Überstand gegenüberliegenden Seite des stirnseitigen Ausschnitts begrenzt, sodass der stirnseitige Ausschnitt in der Form eines Schlitzes ausgebildet ist. Dieser Schlitz kann sich insbesondere über einen Großteil der Breite der Leiterplatte entlang ihrer Stirnseite erstrecken. Die beiden Überstände begrenzen den Schlitz in Richtung der Oberflächen der Leiterplatte. Durch die Verwendung eines zweiten Überstands wird die Stabilität verbessert. Zudem kann auch eine Klemmung der Kontaktierungsleiterplatte zwischen den beiden Überständen erreicht werden, wodurch sich Vorteile in der Montage ergeben. Weiterhin ergeben sich zusätzliche Möglichkeiten hinsichtlich der Kontaktierung und der Anordnung der entsprechenden Metallfläche bzw. Kontaktierungsmetallfläche.

In einer bevorzugten Ausgestaltung umfasst die Leiterplatte eine zweite Metallfläche zum Kontaktieren mit einer zweiten Kontaktierungsmetallfläche auf einer der ersten Kontaktierungsmetallfläche gegenüberliegenden Seite der Kontaktierungsleiterplatte, wenn die Kontaktierungsleiterplatte in dem stirnseitigen Ausschnitt aufgenommen ist. Hierbei ist die zweite Metallfläche in dem stirnseitigen Ausschnitt an dem zweiten Überstand parallel zu der Leiterplatte angeordnet. Durch die Verwendung einer weiteren Metallfläche, die auf einer gegenüberliegenden Seite am zweiten Überstand angeordnet ist, kann die mechanische Stabilität weiter verbessert werden. Zudem wird es möglich, dass beidseitige elektrische Kontaktierungen zwischen der Leiterplatte und der Kontaktierungsleiterplatte verwendet werden. Es kann weiterer Bauraum eingespart werden.

In einer bevorzugten Ausgestaltung ist ein Abstand zwischen dem ersten Überstand und dem zweiten Überstand kleiner als eine Summe aus einer Dicke der Kontaktierungsleiterplatte, einer Höhe einer vordefinierten Menge eines Lötmaterials auf der ersten Kontaktierungsmetallfläche, einer Höhe einer vordefinierten Menge eines Lötmaterials auf der zweiten Kontaktierungsmetallfläche, einer Höhe einer vordefinierten Menge eines Lötmaterials auf der ersten Metallfläche und einer Höhe einer vordefinierten Menge eines Lötmaterials auf der zweiten Metallfläche. Dadurch, dass die Dicke der Kontaktierungsleiterplatte mit aufgebrachtem Lötmaterial größer ist als der Abstand zwischen den Überständen bei aufgebrachtem Lötmaterial, kann ein Festlegen der Kontaktierungsleiterplatte durch Klemmen erfolgen. Dies hat insbesondere beim Herstellungsprozess Vorteile, da bereits vor der Verbindung durch Erhitzen des Lötmaterials eine korrekte Positionierung erreicht werden kann. Zudem ergeben sich bei einem Einklemmen Vorteile hinsichtlich des Wärmeflusses zwischen Lötmaterial und Metallflächen bzw. Kontaktierungsmetallflächen. Die Herstellung wird insoweit weiter vereinfacht. Dabei kann die vordefinierte Menge an Lötmaterial auf einer oder mehrerer der Metallflächen bzw. Kontaktierungsmetallflächen auch Null sein, je nach Ausgestaltung des Prozesses.

In einer bevorzugten Ausgestaltung umfasst die Leiterplatte einen ersten Seitensteg und einen zweiten Seitensteg, durch die der stirnseitige Ausschnitt in Richtung von Seitenkanten der Leiterplatte begrenzt wird, sodass der stirnseitige Ausschnitt in der Form eines beidseitig begrenzten Schlitzes ausgebildet ist. Dabei weisen Innenkanten der Seitenstege in dem stirnseitigen Ausschnitt vorzugsweise einen sich mit steigendem Abstand zu der Stirnseite der Leiterplatte verringernden Abstand zueinander auf, um die Kontaktierungsleiterplatte in dem stirnseitigen Ausschnitt gegenüber der Leiterplatte auszurichten. Durch die Verwendung von Seitenstegen kann die mechanische Stabilität weiter verbessert werden. Der Schlitz zwischen den Überständen wird beidseitig begrenzt. Insbesondere können die Seitenstege dabei an den Seitenkanten der Leiterplatte verlaufen bzw. diese stirnseitig verlängern. Der von dem Überstand bzw. den Überständen und den Seitenstegen umschlossene Raum bildet den Aufnahmebereich für die Kontaktierungsmetallfläche. Eine Anpassung in der Größe ist in entsprechender Weise möglich. Wenn zusätzlich wie oben beschrieben die Seitenstege so ausgebildet sind, dass sie eine trichter- oder keilförmige Öffnung bilden, kann eine Ausrichtung der Kontaktierungsleiterplatte beim Einschieben oder beim Aufnehmen in den stirnseitigen Ausschnitt erreicht werden. Die Kontaktierungsleiterplatte wird insoweit in den stirnseitigen Ausschnitt eingeführt und beim Einführen automatisch an den Innenkanten der Seitenstege entlanggeführt und ausgerichtet bzw. zentriert. Hierdurch ergeben sich weitere Vorteile bei der Herstellung, da eine genaue Ausrichtung ohne weiteren Aufwand umsetzbar ist. Es ergibt sich eine genaue Positionierung der Leiterplatte und Kontaktierungsleiterplatte zueinander, ohne dass hierfür eine aufwändige Zentrierung mittels einer entsprechenden Vorrichtung durchgeführt werden muss.

In einer bevorzugten Ausgestaltung verbinden die Seitenstege den ersten Überstand und den zweiten Überstand. Die Seitenstege erhöhen insoweit weiter die Stabilität der Leiterplatte im Bereich ihrer Stirnseite und im Bereich des Ausschnitts. Es ergibt sich eine hohe mechanische Belastbarkeit.

In einer bevorzugten Ausgestaltung umfasst die Leiterplatte eine Durchgangsöffnung durch den ersten Überstand im Bereich der ersten Metallfläche, durch die Lötmaterial von einer Außenseite des ersten Überstands zu der ersten Metallfläche gelangen kann. Dabei ist die Durchgangsöffnung vorzugsweise als innenmetallisierte Bohrung ausgebildet. Insbesondere kann ein Via als Durchgangsöffnung vorgesehen sein. Durch die Durchgangsöffnung wird die innenliegende Metallfläche mit einem Außenbereich verbunden. Es ergibt sich eine Möglichkeit, der innenliegenden ersten Metallfläche Hitze zuzuleiten. Dies ist erforderlich, um einen Lötprozess in effizienter Weise durchzuführen. Zudem kann Lötmaterial bzw. weiteres Lötmaterial der Kontaktierung zwischen erster Metallfläche und Kontaktierungsmetallfläche zugeführt werden. Letztlich ermöglichen die Durchgangsöffnungen bzw. Vias auch eine elektrische Kontaktierung, falls dies für die Funktion erforderlich ist. Die Herstellung wird weiter vereinfacht. Eine hohe Stabilität kann erreicht werden.

In einer bevorzugten Ausgestaltung liegt eine Außenseite des ersten Überstands mit einer Außenseite der Leiterplatte in einer Ebene. Insbesondere ist es möglich, dass die Leiterplatte und die Kontaktierungsleiterplatte zumindest einseitig gegenüber einander ausgerichtet sind. Die Oberseiten oder die Unterseiten liegen in einer Ebene. Dies bedingt Vorteile in der weiteren Verwendung bzw. im Einbau der verbundenen Leiterplatte und Kontaktierungsleiterplatte.

In einer bevorzugten Ausgestaltung ist die Leiterplatte als mehrschichtige Platine ausgebildet. Der erste Überstand und/oder der zweite Überstand werden durch jeweils mindestens eine Schicht der mehrschichtigen Platine gebildet, vorzugsweise durch zwei äußere Schichten. Der zuvor beschriebene Aufbau mit Ausschnitt und Überstand kann insbesondere effizient hergestellt werden, wenn eine mehrschichtige Platine verwendet wird. Die mehrschichtige Platine ist aus mehreren Schichten aufgebaut. Hierin wird unter Schicht insbesondere eine Festmaterialschicht (insb. Glasfaser) verstanden. Zwischen den Schichten bzw. auf den Außenseiten der Schichten können dann Kupferlagen zum Ausbilden von Leiterbahnen angeordnet sein. Wenn einzelne Schichten im Bereich der Stirnseite der Platine ausgeschnitten sind bzw. teilweise entfernt werden, kann der Ausschnitt im Bereich der Stirnseite der Leiterplatte bereitgestellt werden. Der Herstellungsaufwand wird insoweit deutlich reduziert, da die Ausschnitte an den einzelnen Schichten deutlich einfacher erstellt werden können, als an einer fertigen Platine. Es ergeben sich geringere Kosten für die Herstellung der beanspruchten Leiterplatte bzw. der beanspruchten Leiterplattenanordnung.

In einer bevorzugten Ausgestaltung ist der stirnseitige Ausschnitt durch Fräsen einer inneren Schicht einer mehrschichtigen Platine vor einer Verbindung der Schichten der mehrschichtigen Platine herstellbar. Bereits bevor die verschiedenen Schichten der Platine (ggf. mit den dazwischen angeordneten Materialien, insb. Kupferlage) zusammengefügt werden, wird eine oder mehrere innenliegende Schichten bearbeitet, um den stirnseitigen Ausschnitt herzustellen. Die Bearbeitung vor dem Zusammenfügen der Schichten ist dabei wesentlich einfacher umsetzbar als ein späteres Herstellen des Ausschnitts. Insoweit können weitere Kosten reduziert werden und die Herstellbarkeit verbessert werden. Außerdem wird es durch diesen Aufbau in einfacher Weise ermöglicht, die Metallflächen zur Kontaktierung der Kontaktierungsleiterplatte sowie etwaig verwendete metallisierte Durchgangsbohrungen an den benötigten Stellen anzubringen. In einer bevorzugten Ausgestaltung umfasst die Leiterplatte fünf erste Metallflächen, die in dem stirnseitigen Ausschnitt an dem ersten Überstand parallel zu der Leiterplatte angeordnet sind, und fünf zweite Metallflächen, die in dem stirnseitigen Ausschnitt an dem zweiten Überstand parallel zu der Leiterplatte angeordnet sind. Es gibt insoweit insgesamt zehn Kontaktpunkte zwischen Leiterplatte und Kontaktierungsleiterplatte. Es können also zehn Signale transportiert werden. Zudem ergibt sich eine hohe mechanische Stabilität durch die mehreren Kontaktierungen.

In einer bevorzugten Ausgestaltung umfasst das Verfahren im Schritt des Verbindens ein Verpressen. Zudem wird vor dem Schritt des Verbindens ein Schritt des Einbringens eines Platzhalters in den Ausschnitt zum Aufnehmen eines Pressdrucks ausgeführt. Durch den Platzhalter kann eine mechanische Beschädigung beim Verpressen der mehreren Schichten der mehrschichtigen Platine verhindert werden. Der Platzhalter wird nach der Herstellung wieder entfernt, um den Ausschnitt zum Aufnehmen der Kontaktierungsleiterplatte frei zu machen.

Unter einer Leiterplatte bzw. einer Kontaktierungsleiterplatte wird hierbei insbesondere eine Platine verstanden, auf der elektronische Bauteile angeordnet sein können. Unter einer Metallfläche bzw. Kontaktierungsmetallfläche versteht sich insbesondere ein Lötpad. Unter einem Bereich einer Stirnseite versteht sich eine unmittelbare räumliche Nähe zur Stirnseite. Insbesondere kann der Ausschnitt direkt an der Stirnseite angeordnet sein. Eine Oberfläche der Leiterplatte kann sowohl eine Oberseite als auch eine Unterseite sein. Unter einem Anbinden einer Kontaktierungsleiterplatte versteht sich insbesondere ein festes mechanisches und elektrisches Verbinden.

Die Erfindung wird nachfolgend anhand einiger ausgewählter Ausführungsbeispiele im Zusammenhang mit den beiliegenden Zeichnungen näher beschrieben und erläutert. Es zeigen:
- Fig. 1: eine schematische Darstellung einer Leiterplattenanordnung gemäß der vorliegenden Erfindung;
- Fig. 2: eine schematische Schnittansicht einer erfindungsgemäßen Leiterplatte;
- Fig. 3: eine schematische perspektivische Darstellung der Leiterplattenanordnung im Bereich des Ausschnitts der Leiterplatte;
- Fig. 4: eine schematische Darstellung der Kontaktierung zwischen Leiterplatte und Kontaktierungsleiterplatte bei der erfindungsgemäßen Leiterplattenanordnung;
- Fig. 5: eine weitere Ausführungsform der erfindungsgemäßen Leiterplatte in einer Schnittansicht;
- Fig. 6: eine weitere Ausführungsform der erfindungsgemäßen Leiterplatte in einer Schnittansicht;
- Fig. 7: eine weitere Ausführungsform der erfindungsgemäßen Leiterplatte in einer Schnittansicht;
- Fig. 8: eine weitere Ausführungsform der erfindungsgemäßen Leiterplatte in einer Schnittansicht;
- Fig. 9: eine schematische perspektivische Darstellung einer erfindungsgemäßen Leiterplatte mit einseitiger Abdeckung des Ausschnitts;
- Fig. 10: eine schematische Darstellung einer Ausführungsform der erfindungsgemäßen Leiterplatte mit einer Starrflex-Platine;
- Fig. 11: eine schematische Darstellung der Anwendung eines Bügellötverfahrens zur Herstellung der erfindungsgemäßen Leiterplatte;
- Fig. 12: eine schematische Darstellung des Einbringens eines Platzhalters in den Ausschnitt bei der Herstellung einer erfindungsgemäßen Leiterplatte;
- Fig. 13: eine schematische Darstellung eines alternativen Ansatzes zum Verbinden zweier parallel angeordneter Leiterplatten in einer Schnittansicht;
- Fig. 14: eine schematische perspektivische Darstellung der Ausführungsform der Fig. 13;
- Fig. 15: eine schematische Darstellung einer erfindungsgemäßen Leiterplatte, bei der eine harzgefüllte Durchgangsöffnung vorgesehen ist; und
- Fig. 16: eine schematische Darstellung eines erfindungsgemäßen Verfahrens.

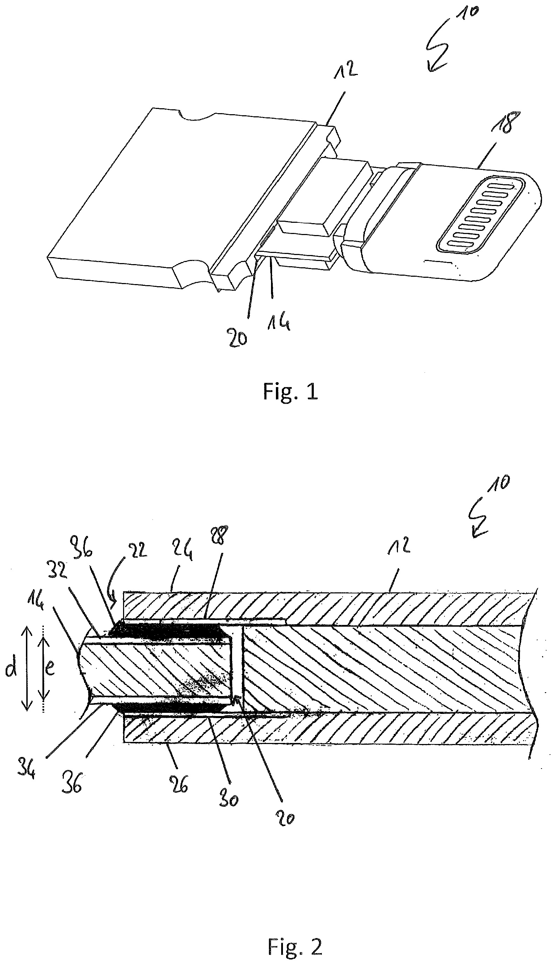

In der Fig. 1 ist schematisch eine erfindungsgemäße Leiterplattenanordnung 10 dargestellt. Die Leiterplattenanordnung 10 umfasst eine Leiterplatte 12 sowie eine Kontaktierungsleiterplatte 14. Die Kontaktierungsleiterplatte ist in einem stirnseitigen Ausschnitt 20 der Leiterplatte 12 aufgenommen. Auf der Kontaktierungsleiterplatte 14 ist ein Stecker 18, im dargestellten Ausführungsbeispiel ein Lightning-Stecker, angeordnet.

Die Leiterplatte 12 ermöglicht es, eine parallel angeordnete Kontaktierungsleiterplatte 14 anzubinden. Unter einem Anbinden wird dabei insbesondere ein mechanisches und elektronisches Kontaktieren verstanden. Im Vergleich zu bisherigen Ansätzen zum Verbinden von parallel angeordneten Leiterplatten ergeben sich durch den erfindungsgemäßen Ansatz Vorteile hinsichtlich des Bauraums und des Herstellungsaufwands. Insbesondere ist es möglich, eine Verbindung auf kleinem Bauraum bzw. mit kleiner Packungsgröße zu realisieren. Dadurch, dass keine separate Verbindung durch Drähte oder separate Bauteile verwendet wird, kann eine effiziente Herstellbarkeit erreicht werden.

In der Fig. 2 ist eine seitliche Schnittansicht durch die Leiterplattenanordnung 10 im Bereich der Verbindung zwischen Leiterplatte 12 und Kontaktierungsleiterplatte 14 dargestellt. Der Ausschnitt 20 wird im dargestellten Ausführungsbeispiel durch einen ersten Überstand 24 der Leiterplatte 12 nach oben hin und einen zweiten Überstand 26 der Leiterplatte 12 nach unten hin begrenzt. In der dargestellten Ausführungsform verläuft zwischen dem ersten Überstand 24 und dem zweiten Überstand 26 insoweit ein Schlitz in der Leiterplatte 12, der dem Ausschnitt 20 entspricht und in den die Kontaktierungsleiterplatte 14 aufgenommen werden kann.

Die Leiterplatte 12 weist weiterhin eine erste Metallfläche 28, die an dem ersten Überstand 24 angeordnet ist, sowie eine zweite Metallfläche 30, die an dem zweiten Überstand 26 angeordnet ist, auf. Die Metallflächen 28, 30 entsprechen vorzugsweise Lötpads und dienen dazu, einen Kontakt zu der Kontaktierungsleiterplatte 14 herzustellen. Hierzu umfasst die Kontaktierungsleiterplatte 14 eine erste Kontaktierungsmetallfläche 32 sowie eine zweite Kontaktierungsmetallfläche 34. Die Kontaktierungsmetallflächen 32, 34 sind dabei im dargestellten Ausführungsbeispiel auf gegenüberliegenden Oberflächen der Kontaktierungsleiterplatte 14 angeordnet. Zwischen den Metallflächen 28, 30 und den Kontaktierungsmetallflächen 32, 34 ist jeweils Lötmaterial 36 dargestellt, durch das die Verbindung zwischen Leiterplatte 12 und Kontaktierungsleiterplatte 14 hergestellt wird. Die Verbindung wird durch einen Stoffschluss mit Lötmaterial hergestellt. Verbunden werden dabei die Kupferlagen der jeweiligen Leiterplatten, wobei die Kupferlagen einzelne Pads (Metallflächen bzw. Kontaktierungsmetallflächen) für die zu kontaktierenden Leiterplatten aufweisen.

Im dargestellten Ausführungsbeispiel ist der Ausschnitt 20 beidseitig (oben und unten in der Darstellung) von zwei Überständen 24, 26 begrenzt. Es versteht sich aber, dass es auch möglich ist, dass nur ein Überstand vorgesehen ist. Dies gilt in entsprechender Weise auch für die Metallflächen 28, 30 und Kontaktierungsmetallflächen 32, 34. Hierbei sind die Überstände 24, 26 insoweit unabhängig von den Metallflächen, sodass es auch möglich ist, dass auf einer Seite lediglich ein Überstand ohne Kontaktierung vorgesehen ist. Weiterhin versteht es sich, dass auf jedem der Überstände je nach Erfordernis auch mehr als eine Metallfläche angebracht sein kann, diese können sowohl quer zur Schnittrichtung als auch innerhalb des Schnittes voneinander getrennt sein. Vorzugsweise gibt es mehrere Metallflächen.

Im dargestellten Ausführungsbeispiel ist die Leiterplatte 12 als mehrschichtige Platine, in der Darstellung insbesondere als dreischichtige Platine, ausgebildet. Der erste Überstand 24 und der zweite Überstand 26 werden durch jeweils eine äußere Schicht der mehrschichtigen Platine gebildet. Insbesondere ist es in diesem Zusammenhang möglich, dass der Ausschnitt 20 durch ein Ausfräsen einer oder mehrerer innerer Schichten hergestellt wird, wobei das Ausfräsen vor einer Verbindung der Schichten erfolgt. In der Darstellung liegen eine Außenseite des ersten Überstands 24 sowie eine Außenseite des zweiten Überstands 26 insoweit jeweils in einer Ebene mit den Außenseiten der Leiterplatte 12. Die Überstände 24, 26 sind sozusagen integraler Bestandteil der Leiterplatte 12. Die Metallflächen 28, 30 sowie die Kontaktierungsmetallflächen 32, 34 sind dabei in der Darstellung jeweils parallel zu der Leiterplatte 12 bzw. der Kontaktierungsleiterplatte 14 angeordnet. Die Metallflächen sind als Lötpads auf der Leiterplatte 12 bzw. der Kontaktierungsleiterplatte 14 angeordnet.

Für die Montage hat es sich als vorteilhaft herausgestellt, dass ein Abstand d zwischen dem ersten Überstand 24 und dem zweiten Überstand 26 kleiner ist als eine Summe aus einer Dicke e der Kontaktierungsleiterplatte 14 und Höhen von vordefinierten Mengen von Lötmaterial 36 auf den Kontaktierungsmetallflächen 32, 34 und den Metallflächen 28, 30 beim Einbringen der Kontaktierungsleiterplatte. Unter einer vordefinierten Menge an Lötmaterial wird dabei die (einstellbare) Menge des Lötmaterials verstanden, die in einem Standardprozess auf die Metallflächen bzw. die Lötpads aufgebracht wird. Dabei ist es möglich, dass vorgesehen ist, auf eine oder mehrere Kontaktierungsmetallflächen bzw. Metallflächen kein Lötmaterial aufzubringen, die vordefinierte Menge kann also auch Null betragen. Dadurch, dass der Abstand d zwischen den Überständen 24, 26 geringer ist als die Summe allen Lötmaterials und der Dicke e der Kontaktierungsleiterplatte 14, wird erreicht, dass es beim Einschieben der Kontaktierungsleiterplatte 14 in den Ausschnitt 20 der Leiterplatte 12 zu einem Aufbiegen der beiden Überstände 24, 26 kommt. Hierdurch kann eine Kontaktierung zwischen dem Lötmaterial und den Metallflächen hergestellt werden, sodass in einem Erwärmungsprozess ein Wärmefluss hergestellt wird und eine gute Kontaktierung erreichbar wird.

Die dargestellte Ausgestaltung erfordert keine spezifische Anpassung an der Kontaktierungsleiterplatte 14. Lediglich die Leiterplatte 12 muss mit dem Ausschnitt 20 insoweit speziell ausgestaltet und in entsprechender Weise ausgelegt sein. Der Ausschnitt 20 ist dabei insoweit ein geometrischer Ausschnitt in einer mittleren Schicht einer mehrschichtigen Platine. Die Dicke des Ausschnitts 20 bzw. der Abstand zwischen den Überständen 24, 26 ist dabei insbesondere von Steifigkeits- und Geometrieauslegungen abhängig. Insbesondere kann der Abstand bzw. die Höhe des Ausschnitts 20 mehr oder weniger einer Dicke der Kontaktierungsleiterplatte 14 sowie etwaig vorhandener Verzinnung (Lötmaterial) entsprechen.

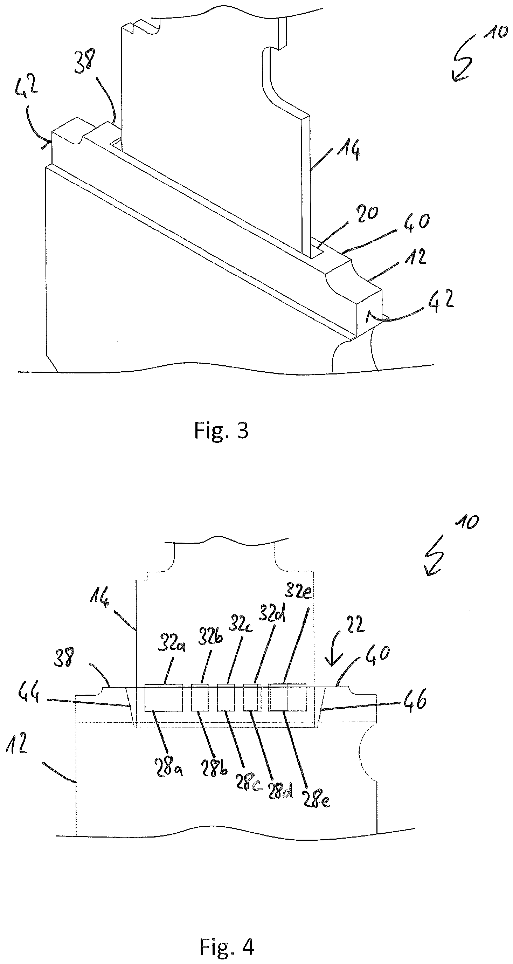

In der Fig. 3 ist die Leiterplattenanordnung 14 perspektivisch dargestellt. Insbesondere ist zu erkennen, dass der Ausschnitt 20 in der Leiterplatte 12 in Form eines Schlitzes ausgebildet ist. Die Kontaktierungsleiterplatte 14 ist in diesem Schlitz aufgenommen. Weiterhin sind zudem ein erster Seitensteg 38 sowie ein zweiter Seitensteg 40 erkennbar, durch die der Ausschnitt 20 in Richtung von Seitenkanten 42 der Leiterplatte 12 begrenzt wird. Insoweit ist der Ausschnitt 20 in der Darstellung in Form eines beidseitig begrenzten Schlitzes ausgebildet.

In der Fig. 4 ist der Aufbau der Leiterplattenanordnung 10 in einer Draufsicht visualisiert. Insbesondere ist erkennbar, dass die Leiterplatte auf der Innenseite des ersten Überstands 24 insgesamt fünf erste Metallflächen 28a bis 28e aufweist. Diesen Metallflächen 28a bis 28e sind fünf Kontaktierungsmetallflächen 32a bis 32e auf der Kontaktierungsleiterplatte 14 zugeordnet. In der Darstellung ist nicht erkennbar, dass auch auf der Seite des zweiten Überstands 26 in entsprechender Weise weitere fünf zweite Metallflächen bzw. weitere fünf zweite Kontaktierungsmetallflächen vorgesehen sein können.

Wie weiterhin dargestellt ist der Ausschnitt 20 der Leiterplatte 12 im gezeigten Ausführungsbeispiel so ausgeführt, dass durch die Kontur eine Selbstzentrierung der Kontaktierungsleiterplatte 14 bei der Montage erfolgt. Hierzu sind insbesondere Innenkanten 44, 46 der Seitenstege 38, 40 in Richtung des Ausschnitts 20 so ausgebildet, dass sie einen sich mit steigendem Abstand zu der Stirnseite 22 der Leiterplatte verringernden Abstand zueinander aufweisen. Hierdurch wird beim Einschieben der Kontaktierungsleiterplatte 14 in den Ausschnitt 20 der Leiterplatte 12 die Kontaktierungsleiterplatte 14 ausgerichtet bzw. zentriert. Die Kontaktierungsleiterplatte 14 kann insoweit entlang der Innenkanten 44, 46 in die Aufnahmeposition in dem Ausschnitt 20 gebracht werden.

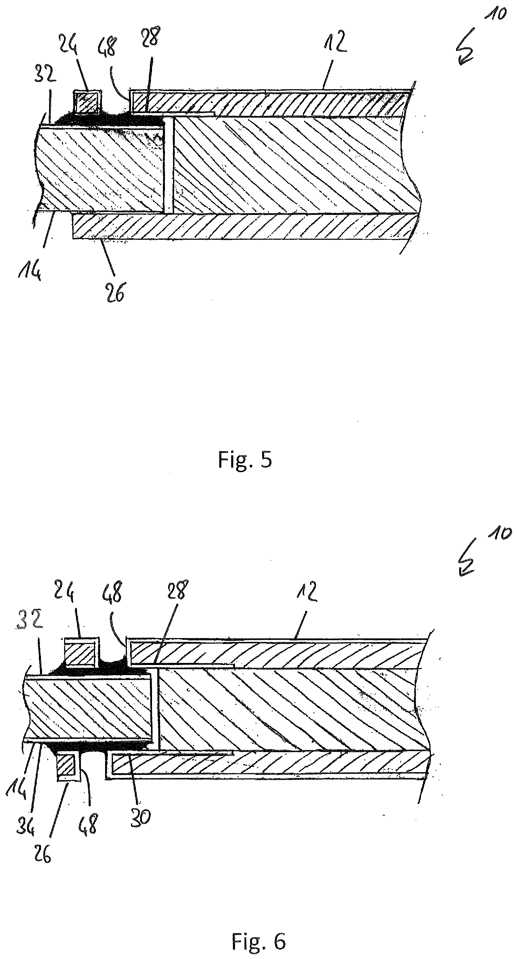

In der Fig. 5 ist eine Ausführungsform der erfindungsgemäßen Leiterplattenanordnung 10 mit einer Leiterplatte 12 dargestellt, die einen Ausschnitt 20 aufweist, der von einem ersten Überstand 24 und einem zweiten Überstand 26 begrenzt wird. In dem ersten Überstand 24 ist eine Durchgangsöffnung 48 im Bereich der ersten Metallfläche 28 vorgesehen, durch die Lötmaterial von einer Außenseite des ersten Überstands 24 zu der ersten Metallfläche 28 gelangen kann. Im dargestellten Ausführungsbeispiel ist die Durchgangsöffnung 48 dabei als innenmetallisierte Bohrung ausgebildet. In anderen Worten sind die Kupferlagen der Leiterplatte 12 von außen nach innen über eine Durchkontaktierung in Form der Durchgangsöffnung 48 verbunden. Diese Durchkontaktierung erfüllt mehrere Funktionen. Zum einen wird ein Wärmetransport zwischen einer Außenseite des ersten Überstands 24 und der ersten Metallfläche 28 erreicht. Die hohe Wärmeleitfähigkeit der leitenden Schicht, also insbesondere der Innenmetallisierung, wird verwendet, um Wärme an die Lötflächen, also an die erste Metallfläche 28, zu überführen. Hierzu kann es vorgesehen sein, dass die Durchgangsöffnung 48 mit Kupfer oder Lötzinn gefüllt ausgeführt ist, um den Wärmewiderstand weiter zu verringern. Zudem bewirkt die Durchgangsöffnung 48 einen Transport von Lötmaterial. Wenn die Durchgangsöffnung 48 wie im dargestellten Ausführungsbeispiel offen ausgeführt ist, kann durch die Kapillarwirkung in der Durchgangsöffnung 48 Lötmaterial eingesaugt werden. Hierdurch wird einerseits der Wärmetransport weiter verbessert und andererseits die Lötqualität an der ersten Metallfläche 28 bzw. an der ersten Kontaktierungsmetallfläche 32 weiter verbessert.

Es versteht sich dabei, dass auch mehrere Durchgangsöffnungen pro Metallfläche bzw. bei mehreren Metallflächen auch jeweils eine oder mehrere Durchgangsöffnungen pro Metallfläche vorgesehen sein können. Zudem kann der Durchmesser so gewählt werden, dass er auf die Geometrie der ersten Metallfläche abgestimmt ist. Insbesondere hat es sich bewährt, mindestens zwei Durchgangsöffnungen pro Metallfläche vorzusehen. In Bezug auf den Durchmesser hat sich ein Durchmesser zwischen 0,1 mm und 0,2 mm bewährt. Diese Parameter hängen von dem verwendeten Lötmaterial, Flussmittel und von der Geometrie ab.

In der Fig. 6 ist eine Ausführungsform der erfindungsgemäßen Leiterplattenanordnung 10 mit einer Leiterplatte 12 mit zwei Überständen 24, 26, einer ersten Metallfläche 28 und einer zweiten Metallfläche 30 sowie zwei Durchgangsöffnungen 48 durch die beiden Überstände 24, 26 dargestellt. Die Durchgangsöffnungen 48 sind gegeneinander versetzt. Es ergibt sich eine vergleichsweise große Gestaltungsfreiheit hinsichtlich eines Versatzes mehrerer Durchgangsöffnungen in alle Richtungen. Insbesondere sind Versatze in der Zeichenebene sowie quer zur Zeichenebene denkbar.

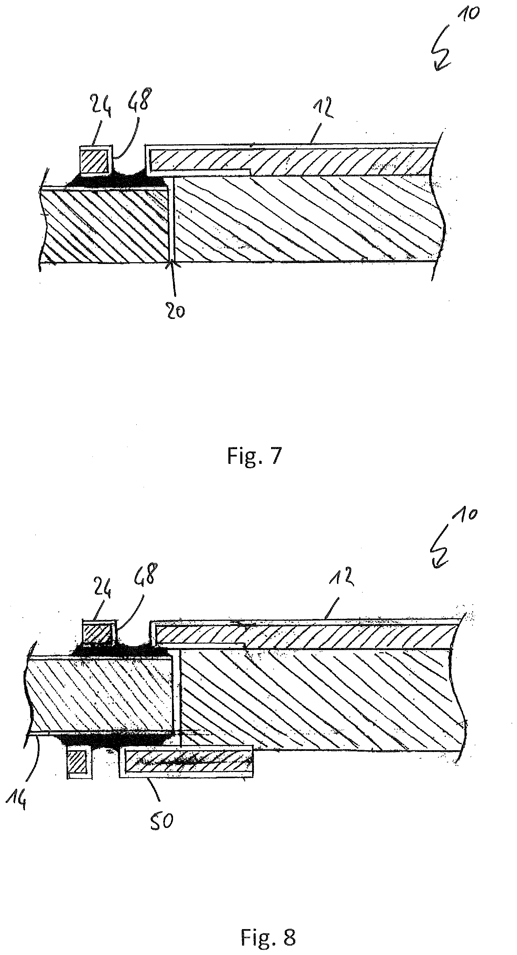

In der Fig. 7 ist eine Ausführungsform der erfindungsgemäßen Leiterplattenanordnung 10 mit einer Leiterplatte 12 dargestellt, bei der der Ausschnitt 20 einseitig durch einen ersten Überstand 24 begrenzt ist. Der Überstand 24 verläuft parallel zu einer Oberfläche der Leiterplatte 12. In dem ersten Überstand 24 ist eine Durchgangsöffnung 48 vorgesehen. Für eine beidseitige Kontaktierung wäre es möglich, zusätzlich auf der offenen, dem ersten Überstand 24 gegenüberliegenden Seite der Kontaktierungsleiterplatte 14 eine weitere Kontaktierung, beispielsweise über Bonddrähte oder Brücken, vorzusehen.

In der Fig. 8 ist eine Ausführungsform der erfindungsgemäßen Leiterplattenanordnung 10 mit einer Leiterplatte 12 mit einseitigem erstem Überstand 24 mit Durchgangsöffnung 48 dargestellt. Auf der dem ersten Überstand 24 gegenüberliegenden Seite der Kontaktierungsleiterplatte 14 wird eine weitere Leiterplatte 50verwendet, um die offene Seite des Ausschnitts 20 zu schließen. Diese weitere Leiterplatte 50 ist wiederum mit der Leiterplatte 12 und der Kontaktierungsleiterplatte 14 stoffschlüssig verbunden. Zudem weist die weitere Leiterplatte ebenfalls eine Durchgangsöffnung 48 auf.

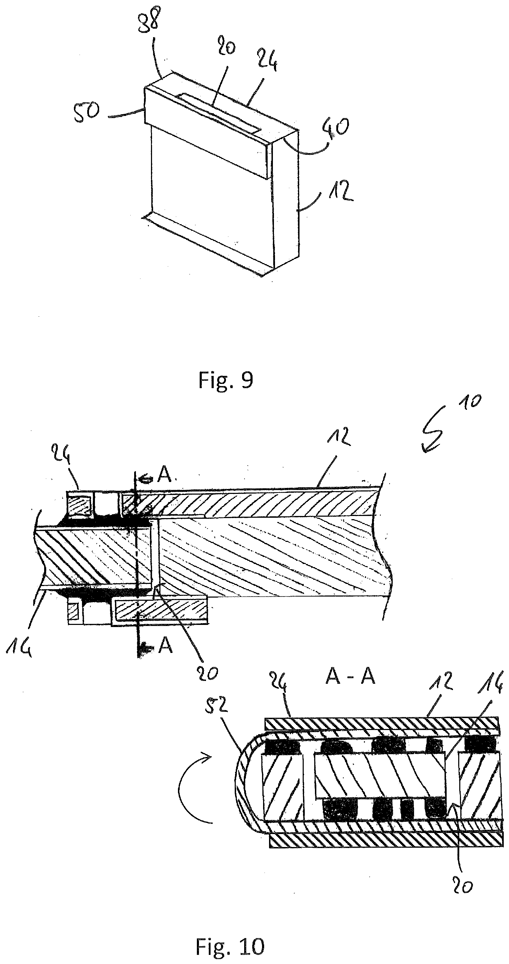

In der Fig. 9 ist eine perspektivische Ansicht der Ausführungsform der Fig. 8 dargestellt. Bei dieser Ausführungsform ist der Ausschnitt 20 der ersten Leiterplatte 12 einseitig durch den ersten Überstand 24 begrenzt. Auf der anderen Seite ist die Leiterplatte 50 zum Abschließen des Ausschnitts 20 angeordnet. Zudem weist die dargestellte Ausführungsform Seitenstege 38, 40 auf.

In der Fig. 10 ist schematisch eine Schnittansicht einer Ausgestaltung der erfindungsgemäßen Leiterplattenanordnung 10 mit einer Leiterplatte 12 als Starrflex-Leiterplatte dargestellt. Die obere Zeichnung zeigt dabei die bereits zuvor eingeführte Schnittansicht. Die untere Zeichnung zeigt die durch A-A gekennzeichnete Schnittansicht der oberen Zeichnung. Der Ausschnitt 20 ist einseitig durch den ersten Überstand 24 begrenzt. Der Ausschnitt 20 wird durch Umklappen eines flexiblen Teils 52 der ersten Leiterplatte 12 geschlossen und mit Lötmaterial verlötet. Das Umklappen erfolgt dabei in Richtung des dargestellten Pfeils. Diese Ausgestaltung hat insbesondere den Vorteil, dass auch Toleranzschwankungen im Bereich von mehreren 1/10 mm ausgeglichen werden können. Allerdings steigen die benötigte Leiterplattenfläche sowie die Prozesskomplexität, sodass eine Umsetzung vergleichsweise aufwändig wird.

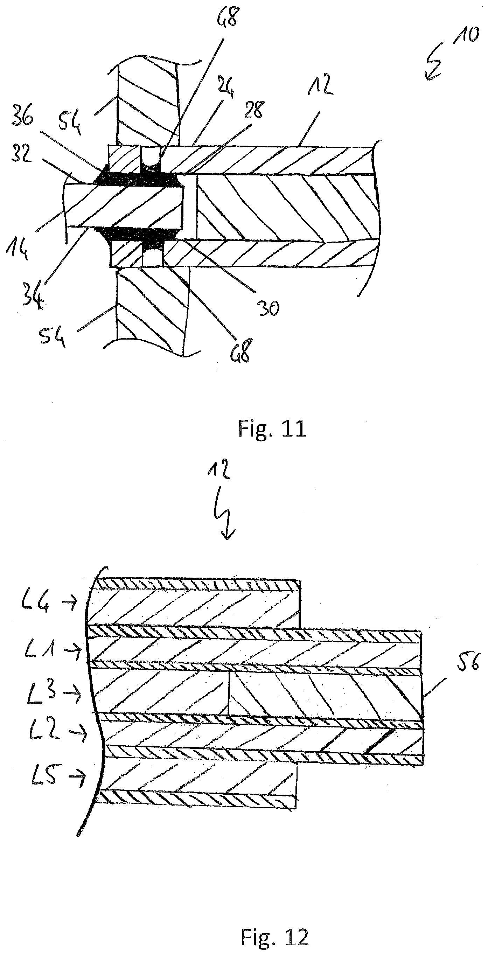

In der Fig. 11 ist schematisch der Verbindungsprozess im Bügellötverfahren dargestellt. Zwei Thermoden 54 einer Bügellötvorrichtung bringen in einem Bügellötprozess Wärme ausgehend von der Außenseite des ersten Überstands 24 der Leiterplatte 12 ein. Die Wärme wird im dargestellten Ausführungsbeispiel durch Durchgangsöffnungen 48 hindurch in Richtung der Metallflächen 28, 30 bzw. der Kontaktierungsmetallflächen 32, 34 der Kontaktierungsleiterplatte 14 und des Lötmaterials 36 geleitet. Der Bügellötkolben kann dabei besonders nah an die Lötstelle gelangen. Zudem wird eine effiziente Fertigung ermöglicht.

In der Fig. 12 ist ein besonders vorteilhafter Schichtenaufbau der Leiterplatte 12 dargestellt. Die Leiterplatte 12 ist aus fünf Schichten L1-L5 aufgebaut. Zwischen den Schichten und jeweils außen sind im dargestellten Beispiel Kupferlagen vorgesehen, in denen Leiterbahnen und Metallflächen ausgebildet sein können.

In einem Herstellprozess können zunächst die Schichten L1 und L2 separat gefertigt werden, wobei diese Fertigung vorzugsweise auch die Metallisierung der Flächen sowie der möglichen Durchkontaktierungen beinhaltet. Anschließend können diese zusammen mit der mittleren Schicht L3 und einem Platzhalter 56 verpresst werden, bevor die Schichten L4, L5 im Außenbereich aufgebracht werden. Durch diesen Aufbau und die gezielte Rückstellung der Schichten L4, L5 gegenüber den inneren Schichten ergeben sich mehrere Vorteile. Zum einen wird es möglich, dass beim Löten ein Bügellötkolben besonders nah an die Lötstelle geführt werden kann. Zum anderen wird die Steifigkeit der Leiterplatte verringert, wodurch geometrische Schwankungen besser ausgeglichen werden können. Zudem besteht eine eindeutige Trennung zwischen einer Fläche der Leiterplatte 12 mit Bauteilen und einer Lötfläche (Metallfläche), wodurch breitere Tracks genutzt werden können. Hierdurch werden die elektronische Verbindung und die Stromtragfähigkeit verbessert. Zudem wird der Lötprozess vereinfacht. Weiterhin kann die Platine dicker ausgestaltet werden, was zu einer steiferen Platine und damit zu stabileren Bestückungsprozessen führt. Es versteht sich, dass auch eine Ausführungsform der Leiterplatte 12 mit anderen Anzahlen von Schichten oder einer auf einen bestimmten Anwendungszweck optimierten geometrischen Ausgestaltung vorteilhaft sein kann. Der Platzhalter 56 wird nach dem Verpressen entfernt. Durch den Platzhalter wird insoweit verhindert, dass es beim Verpressen der Schichten zu einer mechanischen Beschädigung kommt.

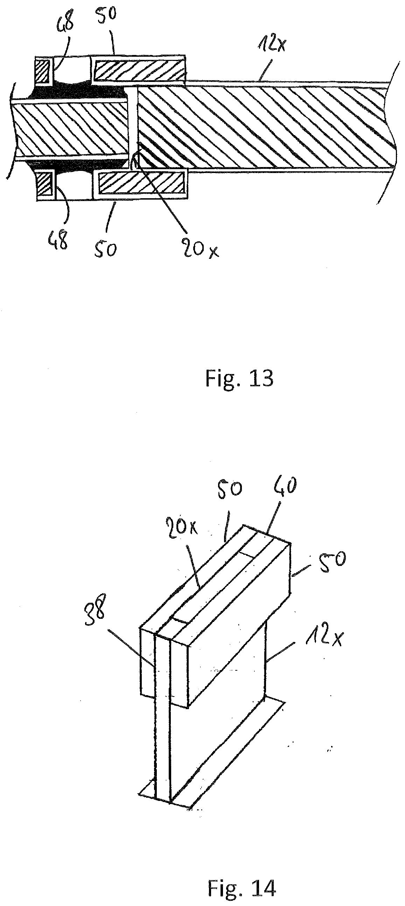

In den Fig. 13 und 14 sind alternative Ausgestaltungen einer Leiterplatte 12x dargestellt, bei denen beide Seiten eines Ausschnitts 20x durch weitere Leiterplatten 50 (im dargestellten Beispiel in der Fig. 13 jeweils mit Durchgangsöffnungen 48) geschlossen sind. In der Fig. 14 sind Seitenstege 38, 40 dargestellt, durch die der Ausschnitt 20 seitlich begrenzt wird. Auch in den alternativen Ausführungsformen der Leiterplatte 12 nach den Fig. 13 und 14 erfolgt die Verbindung mit der Kontaktierungsleiterplatte 14 über einen Stoffschluss. Diese Ausgestaltungen haben den Vorteil, dass keine Besonderheiten bei der Leiterplattenherstellung zu beachten sind. Allerdings werden durch die beiden weiteren Leiterplatten 50 mehr Teile benötigt als bei den zuvor dargestellten Ausführungsformen. Insoweit kann sich eine erhöhte Herstellungskomplexität ergeben. Dennoch kann auch in dieser Weise eine stabile und effizient herstellbare Verbindung zwischen parallel angeordneten Leiterplatten erreicht werden. Es versteht sich, dass auch bei diesen Ausführungsformen die weiteren zuvor und in den Unteransprüchen beschriebenen Ausgestaltungen vorgesehen und vorteilhaft verwendet werden können.

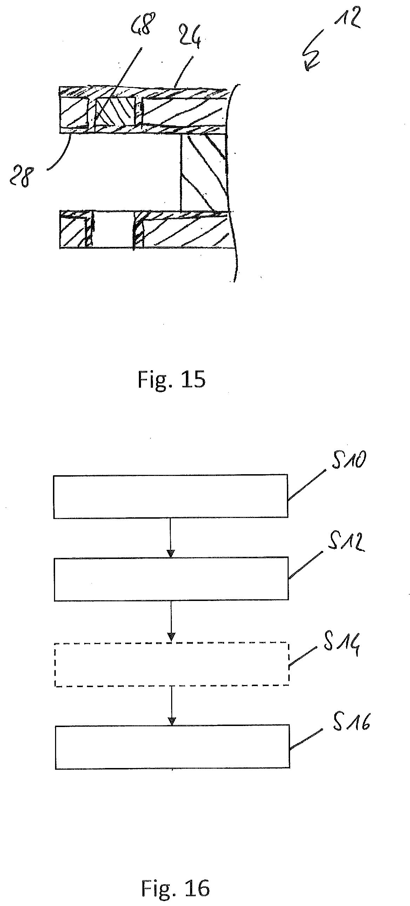

In der Fig. 15 ist dargestellt, dass die Durchgangsöffnung 48 im Bereich des ersten Überstands 24 der Leiterplatte 12 auch gedeckelt und/oder gefüllt sein kann. Hierdurch kann die Wärmeübertragung sichergestellt werden. Gleichzeitig wird verhindert, dass Lötmaterial unerwünscht über die Durchgangsöffnung 48 abfließt. Dies kann in Spezialfällen vorteilhaft sein, wenn weitere Bauteile auf oder nahe an der ersten Metallfläche 28 platziert werden sollen.

In der Fig. 16 ist schematisch der Ablauf des erfindungsgemäßen Verfahrens dargestellt. Das Verfahren umfasst Schritte des Ausfräsens S10 eines Ausschnitts, des Herstellens S12 einer ersten Metallfläche und des Verbindens S16 der ersten Schicht mit der zweiten Schicht. Optional kann der Schritt des Verbindens S16 ein Verpressen umfassen. Weiter optional ist es möglich, dass vor dem Schritt des Verbindens S16 ein Schritt des Einbringens S14 eines Platzhalters vorgesehen ist. Das Verfahren kann beispielsweise zur Steuerung einer entsprechend automatisierten Fertigungsanlage verwendet werden. Insbesondere kann das Verfahren als Steuerungssoftware ausgebildet sein.

Die Erfindung wurde anhand der Zeichnungen und der Beschreibung umfassend beschrieben und erklärt. Die Beschreibung und Erklärung sind als Beispiel und nicht einschränkend zu verstehen. Die Erfindung ist nicht auf die offenbarten Ausführungsformen beschränkt. Andere Ausführungsformen oder Variationen ergeben sich für den Fachmann bei der Verwendung der vorliegenden Erfindung sowie bei einer genauen Analyse der Zeichnungen, der Offenbarung und der nachfolgenden Patentansprüche.

In den Patentansprüchen schließen die Wörter "umfassen" und "mit" nicht das Vorhandensein weiterer Elemente oder Schritte aus. Der undefinierte Artikel "ein" oder "eine" schließt nicht das Vorhandensein einer Mehrzahl aus. Ein einzelnes Element oder eine einzelne Einheit kann die Funktionen mehrerer der in den Patentansprüchen genannten Einheiten ausführen. Ein Element, eine Einheit, eine Vorrichtung und ein System können teilweise oder vollständig in Hard- und/oder in Software umgesetzt sein. Die bloße Nennung einiger Maßnahmen in mehreren verschiedenen abhängigen Patentansprüchen ist nicht dahingehend zu verstehen, dass eine Kombination dieser Maßnahmen nicht ebenfalls vorteilhaft verwendet werden kann. Bezugszeichen in den Patentansprüchen sind nicht einschränkend zu verstehen. Gleiche Bezugszeichen in den Figuren bezeichnen jeweils die gleichen Elemente.

## Patentansprüche

1. Leiterplatte (12) zum Anbinden einer parallel angeordneten Kontaktierungsleiterplatte (14), mit:
einem Ausschnitt (20) im Bereich einer Stirnseite (22) der Leiterplatte zum Aufnehmen der Kontaktierungsleiterplatte, wobei der Ausschnitt stirnseitig offen ist und durch mindestens einen parallel zu einer Oberfläche der Leiterplatte verlaufenden ersten Überstand (24) der Leiterplatte begrenzt wird;
einer ersten Metallfläche (28) zum Kontaktieren mit einer ersten Kontaktierungsmetallfläche (32) auf der Kontaktierungsleiterplatte, wenn die Kontaktierungsleiterplatte in dem stirnseitigen Ausschnitt aufgenommen ist, wobei die erste Metallfläche in dem stirnseitigen Ausschnitt an dem ersten Überstand parallel zu der Leiterplatte angeordnet ist.

2. Leiterplatte (12) nach Anspruch 1, mit einem zweiten Überstand (26), der parallel zu der Oberfläche der Leiterplatte verläuft und den stirnseitigen Ausschnitt (20) auf einer dem ersten Überstand (24) gegenüberliegenden Seite des stirnseitigen Ausschnitts begrenzt, sodass der stirnseitige Ausschnitt in der Form eines Schlitzes ausgebildet ist.

3. Leiterplatte (12) nach Anspruch 2, mit
einer zweiten Metallfläche (30) zum Kontaktieren mit einer zweiten Kontaktierungsmetallfläche (34) auf einer der ersten Kontaktierungsmetallfläche (32) gegenüberliegenden Seite der Kontaktierungsleiterplatte (14), wenn die Kontaktierungsleiterplatte in dem stirnseitigen Ausschnitt (20) aufgenommen ist, wobei
die zweite Metallfläche in dem stirnseitigen Ausschnitt an dem zweiten Überstand (26) parallel zu der Leiterplatte angeordnet ist.

4. Leiterplatte (12) nach Anspruch 3, wobei ein Abstand (d) zwischen dem ersten Überstand (24) und dem zweiten Überstand (26) kleiner ist als eine Summe aus einer Dicke (e) der Kontaktierungsleiterplatte (14), einer Höhe einer vordefinierten Menge eines Lötmaterials (36) auf der ersten Kontaktierungsmetallfläche (32), einer Höhe einer vordefinierten Menge eines Lötmaterials auf der zweiten Kontaktierungsmetallfläche (34), einer Höhe einer vordefinierten Menge eines Lötmaterials auf der ersten Metallfläche (28) und einer Höhe einer vordefinierten Menge eines Lötmaterials auf der zweiten Metallfläche.

5. Leiterplatte (12) nach einem der vorstehenden Ansprüche, mit
einem ersten Seitensteg (38) und einem zweiten Seitensteg (40), durch die der stirnseitige Ausschnitt (20) in Richtung von Seitenkanten (42) der Leiterplatte begrenzt wird, sodass der stirnseitige Ausschnitt in der Form eines beidseitig begrenzten Schlitzes ausgebildet ist, wobei
Innenkanten (44, 46) der Seitenstege in dem stirnseitigen Ausschnitt vorzugsweise einen sich mit steigendem Abstand zu der Stirnseite (22) der Leiterplatte verringernden Abstand zueinander aufweisen, um die Kontaktierungsleiterplatte (14) in dem stirnseitigen Ausschnitt gegenüber der Leiterplatte auszurichten.

6. Leiterplatte (12) nach den Ansprüchen 2 und 5, wobei die Seitenstege (38, 40) den ersten Überstand (24) und den zweiten Überstand (26) verbinden.

7. Leiterplatte (12) nach einem der vorstehenden Ansprüche, mit
einer Durchgangsöffnung (48) durch den ersten Überstand im Bereich der ersten Metallfläche (28), durch die Lötmaterial (36) von einer Außenseite des ersten Überstands (24) zu der ersten Metallfläche gelangen kann, wobei
die Durchgangsöffnung vorzugsweise als innenmetallisierte Bohrung ausgebildet ist.

8. Leiterplatte (12) nach einem der vorstehenden Ansprüche, wobei eine Außenseite des ersten Überstands (24) mit einer Außenseite der Leiterplatte in einer Ebene liegt.

9. Leiterplatte (12) nach einem der vorstehenden Ansprüche, wobei die Leiterplatte als mehrschichtige Platine ausgebildet ist; und
der erste Überstand (24) und/oder der zweite Überstand (26) durch jeweils mindestens eine Schicht der mehrschichtigen Platine gebildet werden, vorzugsweise durch zwei äußere Schichten.

10. Leiterplatte (12) nach Anspruch 9, wobei der stirnseitige Ausschnitt (20) durch Fräsen einer inneren Schicht einer mehrschichtigen Platine vor einer Verbindung der Schichten der mehrschichtigen Platine herstellbar ist.

11. Leiterplatte (12) nach Anspruch 2, wobei die Leiterplatte fünf erste Metallflächen (28a-28e), die in dem stirnseitigen Ausschnitt (20) an dem ersten Überstand (24) parallel zu der Leiterplatte angeordnet sind, und fünf zweite Metallflächen, die in dem stirnseitigen Ausschnitt an dem zweiten Überstand (26) parallel zu der Leiterplatte angeordnet sind, umfasst.

12. Leiterplatte (12) nach einem der vorstehenden Ansprüche, wobei
die Leiterplatte dazu ausgebildet ist, in einem Bügellötprozess Wärme ausgehend von einer Außenseite des ersten Überstands (24) an die erste Metallfläche (28) zu leiten; und
die Wärme vorzugsweise über eine innenmetallisierte Bohrung im Bereich der ersten Metallfläche geleitet wird.

13. Leiterplattenanordnung (10), mit:
einer Leiterplatte (12) nach einem der vorstehenden Ansprüche; und
einer in dem stirnseitigen Ausschnitt (20) der Leiterplatte aufgenommenen Kontaktierungsleiterplatte (14), wobei
auf der Kontaktierungsleiterplatte vorzugsweise ein Stecker (18), besonders bevorzugt ein Lightning-Stecker, angeordnet ist.

14. Verfahren zum Herstellen einer Leiterplatte (12) nach einem der Ansprüche 1 bis 12 oder einer Leiterplattenanordnung (10) nach Anspruch 13, mit den Schritten:
Ausfräsen (S10) eines Ausschnitts (20) im Bereich einer Stirnseite (22) einer ersten Schicht einer mehrschichtigen Platine;
Herstellen (S12) einer ersten Metallfläche (28) auf einer zweiten Schicht der mehrschichtigen Platine; und
Verbinden (S16) der ersten Schicht mit der zweiten Schicht.

15. Verfahren nach Anspruch 14, wobei
der Schritt des Verbindens ein Verpressen (S14) umfasst; und
vor dem Schritt des Verbindens ein Schritt des Einbringens eines Platzhalters (56) in den Ausschnitt (20) zum Aufnehmen eines Pressdrucks ausgeführt wird.
